# FASCICULE DE BREVET EUROPEEN

(11) **EP 3 221 762 B1**
(45) Date de publication et mention de la délivrance du brevet: **09.10.2019**
(21) Numéro de dépôt: 15817443.3
(22) Date de dépôt: 19.11.2015
(51) Int. Cl.: B60K 37/06, H05K 5/00, B60K 35/00, H05K 7/14, G06F 3/0354

(54) **DISPOSITIF D'AFFICHAGE POUR VÉHICULE AUTOMOBILE**
ANZEIGEVORRICHTUNG FÜR EIN KRAFTFAHRZEUG
DISPLAY DEVICE FOR MOTOR VEHICLE

(30) Priorité: 19.11.2014 FR 1402609
(43) Date de publication de la demande: 27.09.2017
(73) Titulaire: DAV, 94046 Créteil Cedex (FR)
(72) Inventeur: DELMAERE, Christophe, 94046 Créteil CEDEX (FR); GELOEN, Richard, 94046 Creteil CEDEX (FR)
(74) Mandataire: Delplanque, Arnaud
(86) Numéro de dépôt international: PCT/FR2015/053145
(87) Numéro de publication internationale: WO 2016/079445

(56) Documents cités:
- WO-A1-2014/102470
- WO-A2-2014/154956
- JP-A- 2002 286 073

## Description

La présente invention concerne un dispositif d'affichage pour véhicule automobile.

Un tel dispositif trouve une application avantageuse pour les tableaux de commande et d'affichage de véhicules automobiles.

La présence de dispositifs d'affichage dans des véhicules automobiles, notamment comprenant des écrans plats est de plus en plus répandue.

Ces dispositifs d'affichage peuvent d'ailleurs comporter seulement l'écran plat ou encore, associée à cet écran plat, une dalle tactile de commande par exemple capacitive ou résistive. Dans ce dernier cas, la dalle tactile permet de déterminer les coordonnées de l'appui d'un doigt d'utilisateur. Les appuis sont ensuite traités par une unité de traitement comportant par exemple un microprocesseur pour commander différentes fonctions du véhicule, comme par exemple des fonctions de climatisation, d'un système audio, d'un système de téléphonie, d'un système multimédia ou encore d'un système de navigation.

On connaît des dispositifs d'affichage intégrés au tableau de commande et d'affichage dans lesquels le dispositif d'affichage est intégré dans un boîtier avec sa carte électronique de commande et avec le cas échéant la dalle tactile.

L'empilement de ces divers éléments est une source de problèmes de tolérances. En effet, même si chaque élément tel que le boîtier, le dispositif d'affichage et la dalle tactile sont réalisés avec une tolérance faible, en production série, leur empilement présente une tolérance totale assez importante ce qui n'est pas acceptable pour des raisons de style.

Par ailleurs, il est de plus en plus demandé à ce que la surface du dispositif d'affichage en vis-à-vis d'un utilisateur affleure la surface de la façade du tableau de commande et d'affichage. On parle également d'un afficheur « flushy », mot anglais pour désigner que la surface du dispositif d'affichage est en alignement avec la façade. Le document WO 2014/102470 A1 montre un exemple d'un tel dispositif d'affichage.

Or, ceci nécessite que la distance entre le dispositif d'affichage, le cas échéant l'écran tactile, d'une part et une marque de référence telle que la paroi arrière du boîtier logeant le dispositif d'affichage d'autre part puisse être maîtrisée avec une grande précision et fiabilité, en particulier avec une précision inférieure à 0,2mm.

La présente invention vise à pallier au moins partiellement certains des problèmes ci-dessus en proposant un dispositif d'affichage dont le positionnement par rapport à un point de référence du boîtier puisse être maîtrisé facilement et avec précision pour pourvoir s'affranchir des problèmes de dispersion et tolérance mécaniques en fabrication série.

A cet effet, la présente invention a pour objet un dispositif d'affichage pour véhicule automobile comportant
- d'une part un module d'affichage comprenant un écran plat présentant sur sa face arrière des pieds de fixation, chaque pied de fixation comportant un taraudage pour recevoir une vis de fixation, et
- d'autre part un boîtier logeant le module d'affichage, ledit boîtier présentant une paroi de fond et sur laquelle sont fixés par vissage les pieds de fixation de l'écran plat,
caractérisé en ce qu'il comprend en outre une membrane en matière élastique disposée entre les pieds de fixation et recouvrant chaque pied de fixation de manière à être interposée entre les pieds de fixation et la paroi de fond du boîtier, et en ce que les vis de fixation de l'écran plat traversent la paroi de fond et la membrane en matière élastique pour coopérer avec le taraudage de chaque pied.

La membrane se fixe facilement sur l'arrière de l'écran d'affichage, en particulier par le fait de recouvrir les pieds de fixation. En engageant les vis de fixation au travers de la membrane, on comprime celle-ci et on peut ajuster de manière très précise la position en z du module d'affichage.

Le dispositif d'affichage peut présenter une ou plusieurs des caractéristiques suivantes prises seule ou en combinaison :
La membrane en matière élastique est tendue entre les pieds de fixation, ce qui permet d'être contre l'arrière de l'écran d'affichage ce qui permet de protéger l'écran par exemple contre des poussières.

La membrane en matière élastique peut être réalisée en élastomère, en particulier en silicone et présenter une dureté SHORE compris en particulier entre 40 et 60, notamment 50.

Le dispositif comprend en outre une carte à circuit imprimé disposée entre la membrane en matière élastique disposée contre la face arrière de l'écran plat et la paroi de fond du boîtier.

La membrane possède également une fonction de protection pour la carte à circuit imprimé notamment contre des poussières et joue un rôle d'étanchéité en particulier en enfermant l'espace autour de la carte à circuit imprimé.

Le boîtier est réalisé en métal, notamment en magnésium.

La paroi de fond du boîtier comprend par exemple des protubérances en contact avec une face de la carte à circuit électrique servant de liaison de masse et la membrane comprend au moins au niveau d'une des protubérances de la paroi de fond du boîtier un plot de compression pour plaquer la carte à circuits imprimés contre cette protubérance de la paroi de fond du boîtier.

Le plot de compression de la membrane permet d'assurer de maintenir la liaison de masse même en cas de fortes vibrations auxquelles le dispositif d'affichage peut être soumise

Le module d'affichage peut comporter en outre une dalle tactile fixée sur l'écran plat d'affichage.

La dalle tactile est par exemple fixée sur l'écran plat d'affichage par un adhésif double face.

L'invention concerne également un procédé d'assemblage d'un dispositif d'affichage tel que défini ci-dessus, caractérisé en ce que l'on fixe l'écran plat par des vis de fixation traversant la paroi de fond du boîtier par coopération avec les taraudages aux pieds de fixation et on ajuste la distance entre l'écran plat ou la dalle tactile disposée sur l'écran plat d'une part et une référence sur la face arrière de la paroi de fond du boîtier d'autre part à une valeur prédéfinie.

Selon un aspect particulier, on mesure lors du vissage la distance entre l'écran plat ou la dalle tactile disposée sur l'écran plat d'une part et une référence sur la face arrière de la paroi de fond du boîtier d'autre part et on arrête le vissage lorsque la valeur prédéfinie est atteinte.

D'autres caractéristiques et avantages de l'invention ressortiront de la description suivante, donnée à titre d'exemple, sans caractère limitatif, en regard d'un dessin annexé montrant en une vue en coupe un exemple réalisation d'un dispositif d'affichage selon l'invention.

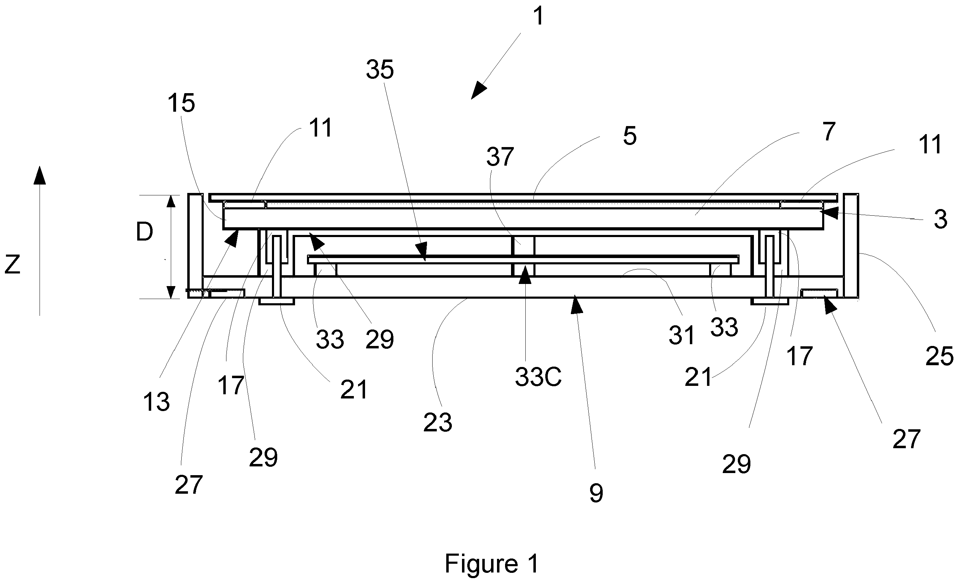

Par la référence 1, on désigne sur la figure 1 de façon globale un dispositif d'affichage 1 pour véhicule automobile selon un exemple de réalisation.

Un tel dispositif d'affichage 1 peut par exemple être installé au niveau de la planche de bord, par exemple à un niveau central pour être aussi bien accessible pour le conducteur que pour un passager du véhicule.

Selon l'exemple représenté, le dispositif d'affichage 1 comporte, vu du haut vers le bas sur la figure 1, d'une part un module d'affichage 3 formé d'une dalle tactile 5 et d'un écran plat d'affichage 7, et d'autre part un boîtier 9 logeant le module d'affichage 3.

La dalle tactile 5 du module d'affichage 3 est par exemple une dalle tactile capacitive, réalisée de façon transparente pour permettre de voir les informations affichées sur l'écran plat d'affichage 7.

Ainsi, on peut prévoir de réaliser la dalle tactile 5 par deux plaques transparentes rigides, par exemple en verre ou en polycarbonate cristal, collées l'une à l'autre par une colle optique et prenant en sandwich des pistes électriques transparentes reliées à une unité électronique pour la détection capacitive. La plaque supérieure eut être recouverte d'un film polariseur pour améliorer la visibilité de l'écran plat 7 dans toutes les conditions de lumière ambiante.

La dalle tactile 5 est par exemple fixée par collage au moyen d'un adhésif double face 11 à l'écran plat 7.

Selon une version simplifiée non représentée du module d'affichage 3, ce dernier ne comporte que l'écran plat 7 d'affichage.

L'écran plat 7 est par exemple un écran à cristaux liquides, TFT, un écran LCD, LED ou un écran OLED. La face arrière 13 de l'écran plat, opposée à celle présentant les LED ou LCD etc, ainsi que les faces latérales 15 sont formés par un cadre de support rigide.

Pour la fixation de l'écran plat 7 dans le boîtier 9, la face arrière 13 présente des pieds de fixation 17 comportant chacun un taraudage pour recevoir une vis de fixation 21.

Le boîtier 9 est par exemple réalisé en métal pour conduire, comme on le verra plus loin, des décharges électrostatiques éventuelles à la masse. Comme métal, on utilisera de préférence du magnésium notamment de haute pureté pour son faible poids, sa bonne résistance mécanique, sa bonne tenue à la corrosion, même sans post-traitement, et sa facilité de façonnage, par exemple par moulage basse pression (« die casting » en anglais).

Le boîtier 9 comporte une paroi de fond 23 et des parois latérales 25. Il est donc ouvert vers le haut (vu sur la figure 1).

Sur la face arrière de la paroi de fond 23 du boîtier 9, ce dernier comporte des références ou points de référence 27 par rapport auxquels la distance D avec la face supérieure de dalle tactile 5 ou, pour la version simplifiée sans dalle tactile 5, avec la face supérieure de l'écran plat 7 doit être réglée avec précision.

En outre, le dispositif d'affichage 1 comprend une membrane 29 en matière élastique, notamment en élastomère, en particulier en silicone.

La membrane 29 présente par exemple une dureté SHORE compris entre 40 et 60, notamment 50.

La membrane 29 est disposée, notamment tendue entre les pieds de fixation 17 et recouvre chaque pied de fixation 17 de manière à être interposée entre les pieds de fixation 17 et la paroi de fond 23 du boîtier 9.

Les vis de fixation 21 de l'écran plat 7 traversent la paroi de fond 23 et la membrane 29 en matière élastique pour coopérer avec le taraudage de chaque pied de fixation 17. Les vis de fixation 21 sont par exemple équipées d'un frein, en particulier en polyamide, pour prévenir tout dévissage intempestif dû par exemple à des vibrations.

Ainsi, la membrane 29 se fixe facilement sur l'arrière de l'écran plat 7, en particulier par le fait de recouvrir les pieds de fixation 17 par une seule pièce à positionner. En engageant les vis de fixation 21 au travers de la membrane 29, on peut comprimer celle-ci et on peut ajuster de manière très précise la position en z, et donc de la distance D, du module d'affichage par rapport aux références 27 du boîtier 9.

On note que l'arrêt de l'opération de vissage des vis 21 n'est pas en fonction d'un couple, mais en fonction de la distance D à obtenir entre le module d'affichage 3 et la ou les références 27. La membrane 29 peut ainsi être comprimée pour compenser les dispersions ou tolérances de fabrication des diverses éléments du dispositif d'affichage 1.

Par ailleurs, la face 31 de la paroi de fond 23 du boîtier 9 présente des protubérances 33 sur lesquelles repose une carte à circuits imprimés 35 servant par exemple au pilotage de la dalle tactile 5 et reliée électriquement, par exemple par une nappe de fils conducteurs (non représentés) à celle-ci.

La carte à circuits imprimés 35 est donc disposée entre la membrane 29 en matière élastique et la paroi de fond 23 du boîtier 9.

La membrane 29 possède ainsi également une fonction de protection de la carte à circuits imprimés 35, notamment contre des poussières et joue un rôle d'étanchéité.

Au moins une des zones de la carte à circuit imprimé 35 en contact avec les protubérances 33, notamment une zone centrale 33C est électriquement conducteur et sert de liaison électrique entre la masse de la carte à circuit imprimés 35 et le boîtier 9, ceci pour évacuer des éventuelles décharges électrostatiques vers la masse et ainsi éviter d'endommager la dalle tactile 5.

Pour garantir cette fonction même dans des conditions difficiles, notamment en cas de fortes vibrations, la membrane 29 comprend au moins au niveau de la protubérance 33C un plot de compression 37 pour plaquer la carte à circuits imprimés 35 contre cette protubérance 33C de la paroi de fond 23 du boîtier 9.

Le plot de compression 37 de la membrane 29 permet d'assurer et de maintenir la liaison de masse même en cas de fortes vibrations auxquelles le dispositif d'affichage 1 peut être soumises.

Pour l'assemblage du dispositif d'affichage 1 ci-dessus, on fixe l'écran plat 7 par des vis de fixation 17 traversant la paroi de fond 23 du boîtier 9 par coopération les taraudages des pieds de fixation 17 et on ajuste la distance D entre l'écran plat 7 ou la dalle tactile 5 disposée sur l'écran plat 7 d'une part et une référence 27 sur la face arrière de la paroi de fond 23 du boîtier 9 d'autre part à une valeur prédéfinie.

De plus, on prévoit de mesurer lors du vissage la distance D et on arrête le vissage lorsque la valeur prédéfinie est atteinte. Ainsi, l'assemblage peut être automatisé et le vissage est asservi par la mesure de la distance D.

On comprend que le dispositif d'affichage 1 selon l'invention peut être réalisé avec une faible dispersion dans les dimensions de fabrication. La membrane 29 joue non seulement comme un tampon pour pemettre de maîtriser des tolérances de fabrication, mais elle joue aussi un rôle de protection vis-à-vis de la carte à circuits imprimés 35 d'une part contre les poussières et d'autre part contre les conséquences potentiellement néfastes de décharges électrostatiques.

## Revendications

1. Dispositif d'affichage (1) pour véhicule automobile comportant
- d'une part un module d'affichage (3) comprenant un écran plat (7) présentant sur sa face arrière des pieds de fixation (17), chaque pied de fixation (17) comportant un taraudage pour recevoir une vis de fixation (21), et
- d'autre part un boîtier (9) logeant le module d'affichage (3), ledit boîtier (9) présentant une paroi de fond (23) et sur laquelle sont fixés par vissage les pieds de fixation (1) de l'écran plat (7),
**caractérisé en ce qu'**il comprend en outre une membrane en matière élastique (29) disposée entre les pieds de fixation (17) et recouvrant chaque pied de fixation (17) de manière à être interposée entre les pieds de fixation (17) et la paroi de fond (23) du boîtier (9), et **en ce que** les vis de fixation (17) de l'écran plat (7) traversent la paroi de fond (23) et la membrane en matière élastique (29) pour coopérer avec le taraudage de chaque pied (17).

2. Dispositif selon la revendication 1, **caractérisé en ce que** la membrane en matière élastique (29) est tendue entre les pieds de fixation (17).

3. Dispositif selon la revendication 1 ou 2, **caractérisé en ce que** la membrane en matière élastique (29) est réalisée en élastomère, en particulier en silicone.

4. Dispositif selon l'une quelconque des revendications 1 à 3, **caractérisé en ce que** la matière élastique de la membrane (29) présente une dureté SHORE compris entre 40 et 60, notamment 50.

5. Dispositif selon l'une quelconque des revendications 1 à 4, **caractérisé en ce qu'**il comprend en outre une carte à circuit imprimé (35) disposée entre la membrane en matière élastique (29) disposée contre la face arrière de l'écran plat (7) et la paroi de fond (23) du boîtier (9).

6. Dispositif selon l'une quelconque des revendications 1 à 5, **caractérisé en ce que** le boîtier (9) est réalisé en métal, notamment en magnésium.

7. Dispositif selon l'une quelconque des revendications 6 et 7 pris ensemble, **caractérisé en ce que** la paroi de fond (23) du boîtier comprend des protubérances (33) en contact avec une face de la carte à circuit électrique (35) servant de liaison de masse et **en ce que** la membrane (29) comprend au moins au niveau d'une des protubérances (33C) de la paroi de fond (23) du boîtier (9) un plot de compression (37) pour plaquer la carte à circuits imprimés (35) contre cette protubérance (33C) de la paroi de fond (23) du boîtier (9).

8. Dispositif selon l'une quelconque des revendications 1 à 7, **caractérisé en ce que** le module d'affichage (3) comporte en outre une dalle tactile (5) fixée sur l'écran plat d'affichage (7).

9. Dispositif selon la revendication 8, **caractérisé en ce que** la dalle tactile (5) est fixée sur l'écran plat d'affichage (7) par un adhésif double face (11).

10. Procédé d'assemblage d'un dispositif d'affichage selon l'une quelconque des revendications 1 à 9, **caractérisé en ce que** l'on fixe l'écran plat (7)par des vis de fixation (21) traversant la paroi de fond (23) du boîtier (9) par coopération avec les taraudages aux pieds de fixation (17) et on ajuste la distance (D) entre l'écran plat (7) ou la dalle tactile (5) disposée sur l'écran plat (7) d'une part et une référence (27) sur la face arrière de la paroi de fond (23) du boîtier (9) d'autre part à une valeur prédéfinie.

11. Procédé selon la revendication 10, **caractérisé en ce que** l'on mesure lors du vissage la distance (D) entre l'écran plat (7) ou la dalle tactile (5) disposée sur l'écran plat (7) d'une part et une référence (27) sur la face arrière de la paroi de fond (23) du boîtier d'autre part et on arrête le vissage lorsque la valeur prédéfinie (D) est atteinte.

## Patentansprüche

1. Anzeigevorrichtung (1) für ein Kraftfahrzeug, aufweisend
- zum einen ein Anzeigemodul (3), das einen Flachbildschirm (7) umfasst, der auf seiner Rückseite Befestigungsfüße (17) aufweist, wobei jeder Befestigungsfuß (17) ein Gewinde für die Aufnahme einer Befestigungsschraube (21) aufweist, und
- zum anderen ein Gehäuse (9), welches das Anzeigemodul (3) aufnimmt, wobei das Gehäuse (9) eine Bodenwand (23) aufweist und auf der die Befestigungsfüße (1) des Flachbildschirms (7) schraubend befestigt sind,
**dadurch gekennzeichnet, dass** sie ferner eine Membran aus elastischem Material (29) umfasst, die zwischen den Befestigungsfüßen (17) angeordnet ist und jeden Befestigungsfuß (17) bedeckt, so dass sie zwischen den Befestigungsfüßen (17) und der Bodenwand (23) des Gehäuses (9) angeordnet ist, und dass die Befestigungsschrauben (17) des Flachbildschirms (7) die Bodenwand (23) und die Membran aus elastischem Material (29) durchqueren, um mit dem Gewinde jedes Fußes (17) zusammenzuwirken.

2. Vorrichtung nach Anspruch 1, **dadurch gekennzeichnet, dass** die Membran aus elastischem Material (29) zwischen den Befestigungsfüßen (17) gespannt ist.

3. Vorrichtung nach Anspruch 1 oder 2, **dadurch gekennzeichnet, dass** die Membran aus elastischem Material (29) aus einem Elastomer, vor allem aus Silikon, hergestellt ist.

4. Vorrichtung nach einem der Ansprüche 1 bis 3, **dadurch gekennzeichnet, dass** das elastische Material der Membran (29) eine SHORE-Härte, die zwischen 40 und 60 liegt, insbesondere von 50, aufweist.

5. Vorrichtung nach einem der Ansprüche 1 bis 4, **dadurch gekennzeichnet, dass** sie ferner eine Karte mit gedrucktem Schaltkreis (35) umfasst, die zwischen der Membran aus elastischem Material (29), die an der Rückseite des Flachbildschirms (7) angeordnet ist, und der Bodenwand (23) des Gehäuses (9) angeordnet ist.

6. Vorrichtung nach einem der Ansprüche 1 bis 5, **dadurch gekennzeichnet, dass** das Gehäuse (9) aus Metall, insbesondere aus Magnesium, hergestellt ist.

7. Vorrichtung nach einem der gemeinsam herangezogenen Ansprüche 6 und 7, **dadurch gekennzeichnet, dass** die Bodenwand (23) des Gehäuses Vorsprünge (33) in Kontakt mit einer Seite der Karte mit elektrischem Schaltkreis (35) umfasst, die als Masseverbindung dienen, und dass die Membran (29) mindestens im Bereich von einem der Vorsprünge (33C) der Bodenwand (23) des Gehäuses (9) einen Kompressionsstift (37) umfasst, um die Karte mit gedruckten Schaltkreisen (35) gegen diesen Vorsprung (33C) der Bodenwand (23) des Gehäuses (9) zu drücken.

8. Vorrichtung nach einem der Ansprüche 1 bis 7, **dadurch gekennzeichnet, dass** das Anzeigemodul (3) ferner ein Touchpad (5) aufweist, das auf dem Anzeige-Flachbildschirm (7) befestigt ist.

9. Vorrichtung nach Anspruch 8, **dadurch gekennzeichnet, dass** das Touchpad (5) auf dem Anzeige-Flachbildschirm (7) durch einen doppelseitigen Haftstoff (11) befestigt ist.

10. Verfahren zur Montage einer Anzeigevorrichtung nach einem der Ansprüche 1 bis 9, **dadurch gekennzeichnet, dass** der Flachbildschirm (7) durch Befestigungsschrauben (21), welche die Bodenwand (23) des Gehäuses (9) durchqueren, durch Zusammenwirken mit den Gewinden an den Befestigungsfüßen (17) befestigt wird und der Abstand (D) zwischen einerseits dem Flachbildschirm (7) oder dem Touchpad (5), das auf dem Flachbildschirm (7) angeordnet ist, und andererseits einem Bezugspunkt (27) auf der Rückseite der Bodenwand (23) des Gehäuses (9) auf einen vorher festgelegten Wert eingestellt wird.

11. Verfahren nach Anspruch 10, **dadurch gekennzeichnet, dass** beim Schrauben der Abstand (D) zwischen einerseits dem Flachbildschirm (7) oder dem Touchpad (5), das auf dem Flachbildschirm (7) angeordnet ist, und andererseits einem Bezugspunkt (27) auf der Rückseite der Bodenwand (23) des Gehäuses gemessen wird und das Schrauben eingestellt wird, wenn der vorher festgelegte Wert (D) erreicht ist.

## Claims

1. Display device (1) for a motor vehicle, comprising:
- on the one hand, a display module (3) comprising a flat screen (7) having fastening feet (17) on its rear face, each fastening foot (17) having a tapped hole to receive a fastening screw (21), and
- on the other hand, a housing (9) accommodating the display module (3), said housing (9) having a bottom wall (23) to which the fastening feet (1) of the flat screen (7) are fastened by screwing,
**characterized in that** it further comprises a membrane of elastic material (29) placed between the fastening feet (17) and covering each fastening foot (17) so as to be interposed between the fastening feet (17) and the bottom wall (23) of the housing (9), and **in that** the screws (17) for fastening the flat screen (7) pass through the bottom wall (23) and the membrane of elastic material (29) to interact with the tapped hole of each foot (17).

2. Device according to Claim 1, **characterized in that** the membrane of elastic material (29) extends between the fastening feet (17).

3. Device according to Claim 1 or 2, **characterized in that** the membrane of elastic material (29) is made of elastomer, particularly silicone.

4. Device according to any of Claims 1 to 3, **characterized in that** the elastic material of the membrane (29) has, for example, a Shore hardness in the range from 40 to 60, notably 50.

5. Device according to any of Claims 1 to 4, **characterized in that** it further comprises a printed circuit card (35) positioned between the membrane of elastic material (29) positioned against the rear face of the flat screen (7) and the bottom wall (23) of the housing (9).

6. Device according to any of Claims 1 to 5, **characterized in that** the housing (9) is made of metal, notably magnesium.

7. Device according to either of Claims 6 and 7 considered in combination, **characterized in that** the bottom wall (23) of the housing comprises protuberances (33) in contact with a face of the electrical circuit card (35) serving as a ground connection, and **in that** the membrane (29) comprises, at least at the position of one of the protuberances (33C) of the bottom wall (23) of the housing (9), a compression stud (37) for pressing the printed circuit card (35) toward this protuberance (33C) of the bottom wall (23) of the housing (9) .

8. Device according to any of Claims 1 to 7, **characterized in that** the display module (3) further comprises a touch pad (5) fastened to the flat display screen (7).

9. Device according to Claim 8, **characterized in that** the touch pad (5) is fastened to the flat display screen (7) by a double-sided adhesive (11).

10. Method for assembling a display device according to any of Claims 1 to 9, **characterized in that** the flat screen (7) is fastened by fastening screws (21) passing through the bottom wall (23) of the housing (9), by interaction with the tapped holes in the fastening feet (17), and the distance (D) between the flat screen (7) or the touch pad (5) positioned on the flat screen (7), on the one hand, and a reference (27) on the rear face of the bottom wall (23) of the housing (9), on the other hand, is adjusted to a predefined value.

11. Method according to Claim 10, **characterized in that** the distance (D) between the flat screen (7) or the touch pad (5) positioned on the flat screen (7), on the one hand, and a reference (27) on the rear face of the bottom wall (23) of the housing, on the other hand, is measured during the screwing operation, and the screwing is stopped when the predefined value (D) is reached.
